# FASCICULE DE BREVET EUROPEEN

(11) **EP 4 426 092 B1**
(45) Date de publication et mention de la délivrance du brevet: **25.06.2025**
(21) Numéro de dépôt: 24160727.4
(22) Date de dépôt: 29.02.2024
(51) Int. Cl.: H10N 70/20

(54) **COMMUTATEUR A BASE DE MATERIAU A CHANGEMENT DE PHASE**
SCHALTER AUF BASIS VON PHASENWECHSELMATERIAL
PHASE CHANGE MATERIAL BASED SWITCH

(30) Priorité: 03.03.2023 FR 2302011
(43) Date de publication de la demande: 04.09.2024
(73) Titulaire: Commissariat à l'Energie Atomique et aux Energies Alternatives, 75015 Paris (FR)
(72) Inventeur: MERCIER, Denis, 38054 GRENOBLE CEDEX 09 (FR); REIG, Bruno, 38054 GRENOBLE CEDEX 09 (FR)
(74) Mandataire: Cabinet Beaumont

(56) Documents cités:
- US-A1- 2016 035 973
- US-A1- 2016 056 373
- US-B2- 10 644 067

## Description

### Domaine technique

La présente description concerne de façon générale les dispositifs électroniques. La présente description concerne plus particulièrement les commutateurs à base d'un matériau à changement de phase, capable d'alterner entre une phase cristalline, électriquement conductrice, et une phase amorphe, électriquement isolante.

### Technique antérieure

Diverses applications tirent profit de commutateurs, ou interrupteurs, à base d'un matériau à changement de phase pour permettre ou empêcher une circulation d'un courant électrique dans un circuit. De tels commutateurs peuvent notamment être mis en œuvre dans des applications de communication radiofréquence, par exemple pour commuter une antenne entre des modes d'émission et de réception, activer un filtre correspondant à une bande de fréquences, etc.

Les commutateurs à base d'un matériau à changement de phase existants souffrent toutefois de divers inconvénients.

Un exemple de l'art anterieur, se trouve dans US 2016/056373. Le document divulgue un commutateur RF à base de matériau à changement de phase.

### Résumé de l'invention

Il existe un besoin d'améliorer les commutateurs à base d'un matériau à changement de phase existants.

Pour cela, un mode de réalisation prévoit un commutateur comprenant :
- des première, deuxième, troisième et quatrième électrodes ;
- une première région en un matériau à changement de phase reliant les première et deuxième électrodes ;
- une deuxième région en un matériau à changement de phase reliant les deuxième et troisième électrodes ; et
- une troisième région en un matériau à changement de phase reliant les deuxième et quatrième électrodes.

Selon un mode de réalisation, le commutateur comprend en outre des premier, deuxième et troisième éléments chauffants situés respectivement en vis-à-vis des première, deuxième et troisième régions en matériau à changement de phase, chaque élément chauffant étant électriquement isolé de ladite région située en vis-à-vis.

Selon un mode de réalisation, le troisième élément chauffant est destiné à être commandé indépendamment des premier et deuxième éléments chauffants.

Selon un mode de réalisation, les premier et deuxième éléments chauffants sont destinés à être commandés simultanément.

Selon un mode de réalisation, les premier et deuxième éléments chauffants sont connectés en série entre deux électrodes de commande.

Selon un mode de réalisation, les première, deuxième et troisième régions en matériau à changement de phase sont en un matériau chalcogénure.

Selon un mode de réalisation, chacune des première, deuxième et troisième régions en matériau à changement de phase est en tellurure de germanium ou en germanium-antimoine-tellure.

Selon un mode de réalisation, la troisième région en matériau à changement de phase présente un volume inférieur à celui des première et deuxième régions en matériau à changement de phase.

Selon un mode de réalisation, les première et deuxième régions en matériau à changement de phase présentent, en vue de dessus, des aires différentes.

Selon un mode de réalisation, les première et deuxième régions en matériau à changement de phase présentent, le long de la direction de conduction du commutateur, une même dimension latérale.

Selon un mode de réalisation, les première et deuxième régions en matériau à changement de phase présentent, le long d'une direction orthogonale à la direction de conduction du commutateur, des dimensions latérales différentes.

Un mode de réalisation prévoit un dispositif comprenant un commutateur tel que décrit et un plan de masse auquel est connectée la quatrième électrode du commutateur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues schématiques et partielles, respectivement de dessus et en coupe selon le plan AA de la figure 1A, d'un exemple d'un commutateur à base d'un matériau à changement de phase selon un mode de réalisation ;
la figure 2A, la figure 2B et la figure 2C sont des vues de dessus, schématiques et partielles, illustrant différents états du commutateur des figures 1A et 1B ;
la figure 3 est un schéma électrique équivalant au commutateur des figures 1A et 1B ;
la figure 4 est une vue de dessus, schématique et partielle, d'un exemple de ligne à microruban comprenant le commutateur des figures 1A et 1B selon un mode de réalisation ;
la figure 5 est une vue de dessus, schématique et partielle, d'un exemple de ligne coplanaire comprenant le commutateur des figures 1A et 1B selon un mode de réalisation ;
la figure 6 est une vue de dessus, schématique et partielle, d'un exemple d'un commutateur à base d'un matériau à changement de phase selon un mode de réalisation ; et
la figure 7 est une vue de dessus, schématique et partielle, d'un exemple d'un commutateur à base d'un matériau à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

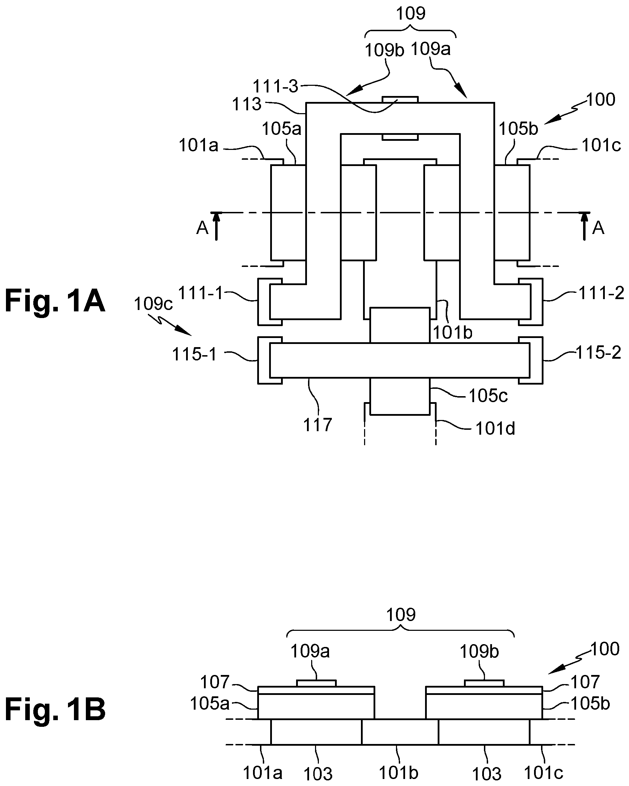

La figure 1A et la figure 1B sont des vues schématiques et partielles, respectivement de dessus et en coupe selon le plan AA de la figure 1A, d'un exemple d'un commutateur 100 à base d'un matériau à changement de phase selon un mode de réalisation.

Dans l'exemple représenté, le commutateur 100 comprend des régions conductrices 101a, 101b, 101c et 101d coplanaires. Les régions conductrices 101a et 101c sont situées de part et d'autre de la région conductrice 101b. Dans l'orientation de la figure 1A, les régions conductrices 101a et 101c sont situées aux extrémités gauche et droite, respectivement, du commutateur 100. La région conductrice 101b est interposée latéralement entre les régions conductrices 101a et 101c. La région conductrice 101d est située en vis-à-vis de la région conductrice 101b. Dans l'orientation de la figure 1A, la région conductrice 101d est située à l'extrémité inférieure du commutateur 100.

Les régions conductrices 101a et 101c sont par exemple des électrodes de conduction du commutateur 100, par exemple destinées à être connectées à un circuit de communication radiofréquence, non détaillé. La région conductrice 101b est par exemple une région intermédiaire, ou région centrale. La région conductrice 101d est par exemple une électrode de référence destinée à être portée à un potentiel de référence, par exemple la masse. La région conductrice 101d est par exemple connectée à la masse.

À titre d'exemple, les régions conductrices 101a, 101b, 101c et 101d sont en un matériau conducteur, par exemple un métal ou un alliage métallique. Chaque région conductrice 101a, 101b, 101c, 101d peut présenter une structure monocouche ou multicouche. Afin de simplifier la réalisation du commutateur 100, les régions conductrices 101a, 101b, 101c et 101d présentent par exemple des structures et des compositions sensiblement identiques, aux dispersions de fabrication près. À titre d'exemple, chaque région conductrice 101a, 101b, 101c, 101d présente, en vue de dessus, un pourtour de forme sensiblement rectangulaire. Cet exemple n'est toutefois pas limitatif, chaque région conductrice 101a, 101b, 101c, 101d pouvant présenter une forme quelconque.

Bien que cela n'ait pas été détaillé, les régions conductrices 101a, 101b, 101c et 101d du commutateur 100 sont par exemple situées sur et en contact avec une face d'une couche isolante, par exemple en dioxyde de silicium, revêtant un substrat, par exemple une plaquette ou un morceau de plaquette en un matériau semiconducteur, par exemple le silicium.

Dans l'exemple représenté, une couche électriquement isolante 103 revêt les faces latérales des régions conductrices 101a, 101b, 101c et 101d et comble les espaces libres s'étendant latéralement entre les régions conductrices 101a, 101b, 101c et 101d. La couche 103, non représentée en figure 1A afin de ne pas surcharger le dessin, isole électriquement les régions conductrices 101a, 101b, 101c et 101d entre elles. Dans l'exemple illustré, la couche isolante 103 affleure la face supérieure des régions conductrices 101a, 101b, 101c et 101d. À titre d'exemple, la couche isolante 103 est en dioxyde de silicium.

Dans l'exemple représenté, le commutateur 100 comprend en outre des régions 105a, 105b et 105c en un matériau à changement de phase. Les régions 105a, 105b et 105c sont disjointes et relient chacune deux régions conductrices adjacentes du commutateur 100. Plus précisément, dans l'exemple illustré, la région 105a relie les régions conductrices 101a et 101b, la région 105b relie les régions conductrices 101b et 101c, et la région 105c relie les régions conductrices 101b et 101d. Dit autrement, la région conductrice 101b est reliée à chacune des autres régions conductrices 101a, 101c et 101d par les régions en matériau à changement de phase 105a, 105b et 105c, respectivement. Chaque région 105a, 105b, 105c en matériau à changement de phase revêt la face supérieure d'une partie de la couche 103 s'étendant latéralement entre les deux régions conductrices adjacentes qu'elle relie, et se prolonge sur et en contact avec une partie de la face supérieure de chacune desdites régions conductrices. Chaque région 105a, 105b, 105c en matériau à changement de phase présente par exemple, en vue de dessus, un pourtour de forme sensiblement rectangulaire. Cet exemple n'est toutefois pas limitatif, chaque région 105a, 105b, 105c pouvant présenter une forme quelconque. Les régions 105a et 105b sont par exemple destinées à transmettre un signal radiofréquence. À titre d'exemple, la région en matériau à changement de phase 105d est connectée à une borne ou à un nœud d'application d'un potentiel de référence, par exemple la masse.

Le commutateur 100 présente, dans l'orientation de la figure 1A, une forme générale en T dont la barre horizontale, parallèle à une direction de conduction du commutateur 100, comprend les régions conductrices 101a, 101b et 101c et les régions en matériau à changement de phase 105a et 105b, et dont la barre verticale, s'étendant le long d'une direction orthogonale à la direction de conduction du commutateur 100, comprend les régions conductrices 101b et 101d et la région en matériau à changement de phase 105c. Cet exemple n'est toutefois pas limitatif, le commutateur 100 pouvant présenter une forme quelconque. La direction de conduction du commutateur 100 et la direction selon laquelle s'étendent la région conductrice 101d et la région 105c peuvent par exemple être obliques.

À titre d'exemple, chaque région 105a, 105b, 105c du commutateur 100 est en un matériau dit « chalcogénure », c'est-à-dire un matériau ou un alliage comprenant au moins un élément chalcogène, par exemple un matériau de la famille du tellurure de germanium, du tellurure d'antimoine ou du germanium-antimoine-tellure, plus communément désigné par l'acronyme « GST ». À titre de variante, au moins l'une des régions 105a, 105b, 105c peut être en dioxyde de vanadium.

La région 105c du commutateur 100 est par exemple dimensionnée différemment des régions 105a et 105b. À titre d'exemple, la région 105c présente un volume, ou une surface active, différente du volume, ou des surfaces actives, de chacune des régions 105a et 105b. À titre de variante, ou de façon complémentaire, la région 105c peut être en un matériau à changement de phase différent de celui des régions 105a et 105b.

Dans l'orientation de la figure 1B, la face supérieure de chaque région 105a, 105b, 105c est revêtue d'une couche électriquement isolante 107. À titre d'exemple, la couche isolante 107 est en un matériau diélectrique et thermiquement conducteur, par exemple le nitrure de silicium ou le nitrure d'aluminium. La couche isolante 107 n'a pas été représentée en figure 1A afin de ne pas surcharger le dessin.

Dans l'exemple illustré, le commutateur 100 comporte en outre des éléments chauffants 109a, 109b et 109c situés sur et en contact avec la face supérieure de la couche 107 à l'aplomb des régions 105a, 105b et 105c, respectivement. Dans cet exemple, chaque élément chauffant 109a, 109b, 109c est électriquement isolé de la région 105a, 105b, 105c sous-jacente par la couche 107. Dans l'exemple représenté, les éléments chauffants 109a et 109b présentent chacun la forme d'une bande rectangulaire s'étendant le long d'une direction sensiblement orthogonale à la direction de conduction du commutateur 100, et l'élément chauffant 109c présente la forme d'une bande rectangulaire s'étendant le long d'une direction sensiblement parallèle à la direction de conduction du commutateur 100. Dans l'exemple illustré en figures 1A et 1B, les éléments chauffants 109a et 109b sont adjacents et forment un unique élément chauffant 109. Cela permet de chauffer les régions 105a et 105b simultanément, la région 105a se trouvant alors toujours dans le même état, amorphe ou cristallin, que la région 105b.

Dans l'exemple illustré en figure 1A, les éléments chauffants 109a et 109b sont connectés en série entre des électrodes de commande 111-1 et 111-2 situées de part et d'autre de la région conductrice 101b. Plus précisément, dans l'exemple représenté, l'élément chauffant 109a est connecté entre l'électrode de commande 111-1 et une électrode de commande intermédiaire 111-3, et l'élément chauffant 109b est connecté entre l'électrode de commande intermédiaire 111-3 et l'électrode de commande 111-2. La présence de l'électrode 111-3 permet avantageusement de réduire les tensions de commande des éléments chauffants 109a et 109b par rapport aux tensions qui devraient être appliquées en l'absence de l'électrode 111-3. Toutefois, l'électrode de commande 111-3 peut, à titre de variante, être omise. Dans l'exemple illustré, les éléments chauffants 109a et 109b font partie d'une même piste conductrice 113, par exemple une piste métallique, dont les extrémités gauche et droite sont connectées respectivement aux électrodes de commande 111-1 et 111-2. Au moins une partie de la piste 113 connectant l'élément chauffant 109a à l'élément chauffant 109b est située à l'aplomb d'une région dépourvue de matériau à changement de phase, par exemple une région électriquement isolante. Dans l'exemple illustré, les éléments chauffants 109a et 109b sont destinés à être commandés de façon simultanée, par exemple par l'application d'une première différence de potentiel entre les électrodes 111-1 et 111-3 et par l'application d'une deuxième différence de potentiel, par exemple sensiblement égale à la première différence de potentiel, entre les électrodes 111-2 et 111-3. À titre d'exemple, l'électrode 111-3 est portée à un potentiel de référence, par exemple la masse, et les électrodes 111-1 et 111-2 sont portées à un potentiel haut.

À titre de variante, les éléments chauffants 109a et 109b peuvent être isolés électriquement l'un de l'autre. Dans ce cas, les éléments chauffants 109a et 109b sont par exemple formés dans des pistes conductrices distinctes, isolées l'une de l'autre et connectées chacune entre des électrodes de commande analogues aux électrodes 111-1 et 111-2. Dans ce cas, les électrodes de commande de chaque élément chauffant 109a, 109b sont par exemple situées de part et d'autre de la direction de conduction du commutateur 100. Les éléments chauffants 109a et 109b peuvent, dans cette variante, être commandés simultanément, par exemple par l'application simultanée d'une différence de potentiel entre les électrodes de commande de chaque élément chauffant 109a, 109b.

Dans l'exemple représenté, l'élément chauffant 109c est connecté entre des électrodes de commande 115-1 et 115-2 et fait partie d'une piste conductrice 117, par exemple une piste métallique, dont les extrémités gauche et droite sont connectées respectivement aux électrodes de commande 115-1 et 115-2 de l'élément chauffant 109c. Dans cet exemple, la piste 117 dont fait partie l'élément chauffant 109c est isolée électriquement de la piste 113 dont font partie les éléments chauffants 109a et 109b, et les électrodes de commande 115-1 et 115-2 sont isolées électriquement des électrodes de commande 111-1 et 111-2. Cela permet de commander l'élément chauffant 109c indépendamment des éléments chauffants 109a et 109b.

À titre d'exemple, les électrodes de commande 111-1, 111-2 et 111-3 des éléments chauffants 109a et 109b du commutateur 100 sont reliées ou connectées à un premier circuit de commande, et les électrodes de commande 115-1 et 115-2 de l'élément chauffant 109c sont reliées ou connectées à un deuxième circuit de commande, par exemple distinct du premier circuit de commande. Afin de ne pas surcharger le dessin, les circuits de commande des éléments chauffants 109a, 109b et 109c n'ont pas été représentés.

Chaque élément chauffant 109a, 109b, 109c présente par exemple une épaisseur de l'ordre de 100 nm et une largeur comprise entre quelques centaines de nanomètres et quelques micromètres. À titre d'exemple, chaque élément chauffant 109a, 109b, 109c est en un métal, par exemple le tungstène, ou en un alliage métallique, par exemple le nitrure de titane. Bien que cela n'ait pas été représenté, le commutateur 100 peut être revêtu d'une couche thermiquement isolante destinée à confiner la chaleur produite par les éléments chauffants 109a, 109b et 109c.

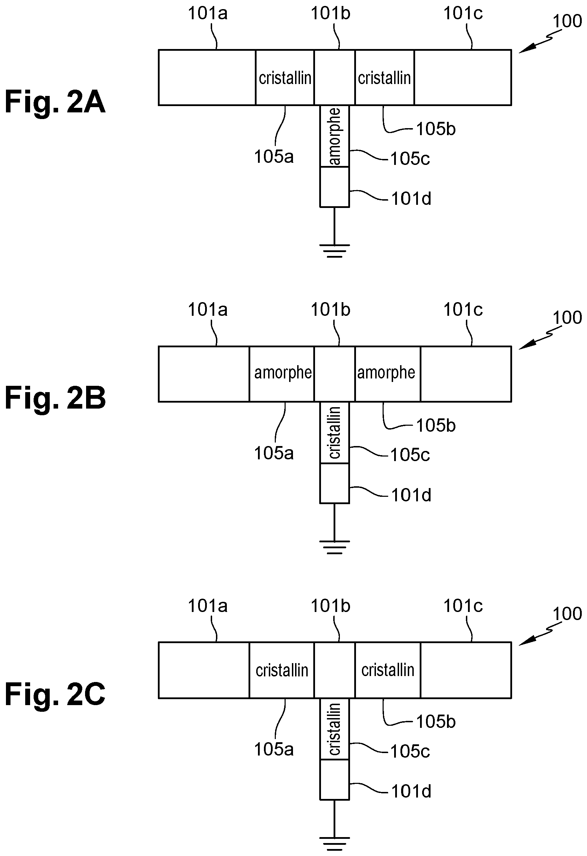

La figure 2A, la figure 2B et la figure 2C sont des vues de dessus, schématiques et partielles, illustrant différents états du commutateur des figures 1A et 1B.

De manière générale, les matériaux à changement de phase sont des matériaux capables d'alterner, sous l'effet d'une variation de température, entre une phase cristalline et une phase amorphe, la phase amorphe présentant une résistivité électrique supérieure à celle de la phase cristalline. Dans le cas du commutateur 100, il est tiré profit de ce phénomène pour obtenir :
- un premier état (figure 2A), appelé « état passant », permettant la circulation d'un courant entre les régions conductrices 101a, 101b et 101c, lorsque le matériau des régions 105a et 105b est dans la phase cristalline et lorsqu'une partie au moins du matériau de la région 105c est dans la phase amorphe ;
- un deuxième état (figure 2B), appelé « état bloqué réfléchissant », empêchant la circulation d'un courant entre les régions conductrices 101a et 101c, lorsqu'une partie au moins du matériau des régions 105a et 105b est dans la phase amorphe et lorsque le matériau de la région 105c est dans la phase cristalline ; et
- un troisième état (figure 2C), appelé « état bloqué absorbant », permettant la circulation d'un courant entre les régions conductrices 101a, 101b et 101d, et éventuellement entre les régions conductrices 101a, 101b et 101c, lorsque le matériau des régions 105a, 105b et 105c est dans la phase cristalline.

Lors des commutations du commutateur 100 entre les états passant et bloqué réfléchissant, les électrodes de commande 111-1 et 111-2 des éléments chauffants 109a et 109b et les électrodes de commande 115-1 et 115-2 de l'élément chauffant 109c sont par exemple simultanément soumises à des tensions de commande provoquant une circulation de courant à travers les éléments chauffants 109a, 109b et 109c. Ce courant entraîne, par effet Joule puis par rayonnement et/ou conduction à l'intérieur de la structure du commutateur 100, notamment à travers les couches 107, une élévation de température des régions 105a, 105b et 105c sous-jacentes depuis leurs faces supérieures, situées en regard des éléments chauffants 109a, 109b et 109c respectifs.

Plus précisément, pour faire basculer le commutateur 100 de l'état bloqué réfléchissant à l'état passant, les régions 105a et 105b en matériau à changement de phase sont chauffées, au moyen des éléments chauffants 109a et 109b, par exemple à une température T1 et pendant une durée d1. La température T1 et la durée d1 sont choisies de sorte à provoquer un changement de phase du matériau des régions 105a et 105b depuis la phase amorphe vers la phase cristalline. La température T1 est par exemple supérieure à une température de cristallisation et inférieure à une température de fusion du matériau des régions 105a et 105b. À titre d'exemple, la température T1 est comprise entre 150 et 350 °C et la durée d1 est inférieure à 1 µs. Dans le cas où les régions 105a et 105b sont en tellurure de germanium, la température T1 est par exemple égale à environ 300 °C et la durée d1 est par exemple comprise entre 100 ns et 1 µs.

Par ailleurs, la région 105c en matériau à changement de phase est chauffée, au moyen de l'élément chauffant 109c, par exemple à une température T2 supérieure à la température T1, et pendant une durée d2 inférieure à la durée d1. La température T2 et la durée d2 sont choisies de sorte à provoquer un changement de phase du matériau de la région 105c depuis la phase cristalline vers la phase amorphe. La température T2 est par exemple supérieure à la température de fusion du matériau à changement de phase. À titre d'exemple, la température T2 est comprise entre 600 et 1 000 °C et la durée d2 est inférieure à 500 ns. Dans le cas où la région 105c est en tellurure de germanium, la température T2 est par exemple égale à environ 700 °C et la durée d2 est par exemple égale à environ 100 ns.

Lors de la commutation du commutateur 100 entre l'état bloqué réfléchissant et l'état passant, l'élément chauffant 105c et les éléments chauffants 105a et 105b sont par exemple commandés de façon simultanée. Cela permet avantageusement de réduire la durée de commutation.

À l'inverse, pour faire basculer le commutateur 100 de l'état passant à l'état bloqué réfléchissant, les régions 105a et 105b sont chauffées, au moyen des éléments chauffants 109a et 109b, par exemple à la température T2 et pendant la durée d2. Par ailleurs, la région 105c est chauffée, au moyen de l'élément chauffant 109c, par exemple à la température T1 et pendant la durée d1.

Ainsi, lors des commutations entre l'état passant et l'état bloqué réfléchissant, les éléments chauffants 109 (109a, 109b) et 109c sont par exemple commandés simultanément et en opposition. À titre d'exemple, l'élément chauffant 109c est destiné à être commandé de sorte à faire passer la région 105c en matériau à changement de phase d'un premier état à un deuxième état (par exemple de l'état cristallin à l'état amorphe) lorsque l'élément chauffant 109 (109a, 109b) est commandé de sorte à faire passer les régions 105a et 105b en matériau à changement de phase du deuxième au premier état (de l'état amorphe à l'état cristallin, dans cet exemple).

La commutation entre les états bloqué réfléchissant et bloqué absorbant est par exemple analogue à la commutation entre les états passant et bloqué réfléchissant décrite ci-dessus, à la différence que seuls les éléments chauffants 109a et 109b sont mis en œuvre pour la commutation entre les états bloqué réfléchissant et bloqué absorbant, le matériau de la région 105c restant dans la phase cristalline lors de cette commutation. À titre d'exemple, pour faire basculer le commutateur 100 de l'état bloqué réfléchissant à l'état bloqué absorbant, les régions 105a et 105b sont chauffées à la température T1 et pendant la durée d1. À l'inverse, pour faire basculer le commutateur 100 de l'état bloqué absorbant à l'état bloqué réfléchissant, les régions 105a et 105b sont par exemple chauffées à la température T2 et pendant la durée d2.

Par ailleurs, la commutation entre les états passant et bloqué absorbant est par exemple analogue à la commutation entre les états passant et bloqué réfléchissant décrite ci-dessus, à la différence que seul l'élément chauffant 105c est mis en œuvre pour la commutation entre l'état passant et l'état bloqué absorbant, le matériau des régions 105a et 105b restant dans la phase cristalline lors de cette commutation. À titre d'exemple, pour faire basculer le commutateur 100 de l'état passant à l'état bloqué absorbant, la région 105c est chauffée à la température T1 et pendant la durée d1. À l'inverse, pour faire basculer le commutateur 100 de l'état bloqué absorbant à l'état passant, la région 105c est par exemple chauffée à la température T2 et pendant la durée d2.

Les valeurs des températures T1 et T2 et des durées d1 et d2 de chauffage peuvent être identiques pour chacune des régions 105a, 105b, 105c. À titre de variante, au moins l'une des régions 105a, 105b, 105c, par exemple la région 105c, peut présenter des valeurs de température T1 et/ou T2 et/ou de durée d1 et/ou d2 de chauffage différentes de celles des autres régions (les régions 105a et 105b, dans cet exemple).

Le commutateur 100 est dit « à chauffage indirect », l'élévation de température du matériau à changement de phase s'obtenant par circulation d'un courant à travers un élément chauffant électriquement isolé du matériau à changement de phase, par opposition aux commutateurs de type « à chauffage direct » qui sont dépourvus d'élément chauffant et dans lesquels l'élévation de température résulte d'une circulation de courant à travers le matériau à changement de phase. Dans le cas d'un commutateur à chauffage direct, les électrodes de commande sont par exemple connectées à deux côtés opposés de la région en matériau à changement de phase, par exemple le long d'une direction orthogonale au chemin de conduction du commutateur. Un inconvénient des commutateurs à chauffage direct tient au fait que, lorsque le commutateur est passant, un chemin de conduction électrique est créé à travers le matériau à changement de phase entre les électrodes de commande et les électrodes de conduction du commutateur. Cela entraîne des courants de fuite qui perturbent le signal transmis entre les électrodes de conduction.

Dans l'exemple représenté, la région conductrice 101b est à un potentiel flottant lorsque les régions 105a, 105b et 105c sont dans l'état amorphe (non conducteur). La région conductrice 101b est par exemple connectée uniquement aux régions en matériau à changement de phase 105a, 105b et 105c.

Un avantage du commutateur 100 tient au fait que l'état bloqué réfléchissant permet d'obtenir une meilleure isolation, par exemple améliorée d'environ -20 dB, entre les régions conductrices 101a et 101c par rapport au cas d'un commutateur analogue mais comprenant une seule région en matériau à changement de phase reliant deux électrodes de conduction. Un autre avantage du commutateur 100 réside dans le fait qu'il est possible de tirer profit de l'état bloqué absorbant pour atténuer le signal transmis entre les régions conductrices 101a et 101c.

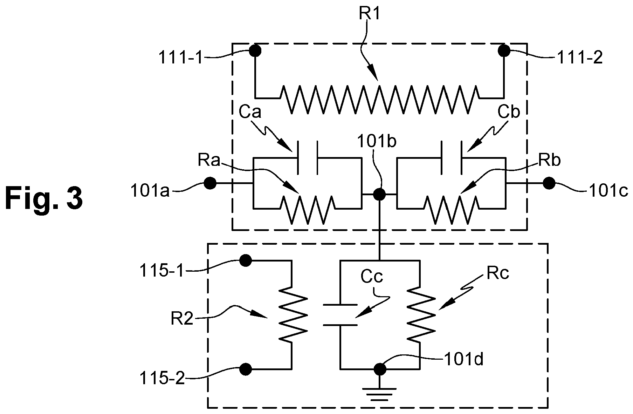

La figure 3 est un schéma électrique équivalant au commutateur 100 des figures 1A et 1B.

Dans l'exemple représenté :
- la région en matériau à changement de phase 105a est symbolisée par un élément résistif Ra et un élément capacitif Ca associés en parallèle entre les régions conductrices 101a et 101b ;
- la région en matériau à changement de phase 105b est symbolisée par un élément résistif Rb et un élément capacitif Cb associés en parallèle entre les régions conductrices 101b et 101c ; et
- la région en matériau à changement de phase 105c est symbolisée par un élément résistif Rc et un élément capacitif Cc associés en parallèle entre les régions conductrices 101b et 101c.

Les éléments résistifs Ra, Rb et Rc symbolisent la résistance électrique des régions en matériau à changement de phase 105a, 105b et 105c du commutateur 100. La résistance de chaque élément résistif Ra, Rb et Rc varie selon que la région 105a, 105b, 105c correspondante est dans l'état cristallin ou dans l'état amorphe. Plus précisément, la résistance de chaque élément résistif Ra, Rb, Rc peut par exemple prendre :
- une première valeur Ra_on, Rb_on, Rc_on correspondant à la résistance de l'élément résistif Ra, Rb, Rc lorsque la région en matériau à changement de phase 105a, 105b, 105c correspondante est dans l'état cristallin ; et
- une deuxième valeur Ra_off, Rb_off, Rc_off supérieure à la première valeur Ra_on, Rb_on, Rc_on et correspondant à la résistance de l'élément résistif Ra, Rb, Rc lorsque la région en matériau à changement de phase 105a, 105b, 105c correspondante est au moins partiellement dans l'état amorphe.

À titre d'exemple, dans un cas où les régions en matériau à changement de phase 105a, 105b et 105c sont en tellurure de germanium, les rapports Ra_off/Ra_on, Rb_off/Rb_on, Rc_off/Rc_on sont de l'ordre de 10⁵. Dans ce cas, le volume de chaque région 105a, 105b, 105c est par exemple dimensionné de sorte que les valeurs Ra_on, Rb_on et Rc_on soient sensiblement égales, et que les valeurs Ra_off, Rb_off et Rc_off soient sensiblement égales.

À titre de variante, dans un cas où les régions en matériau à changement de phase 105a, 105b et 105c sont en GST, les rapports Ra_off/Ra_on, Rb_off/Rb_on, Rc_off/Rc_on sont par exemple de l'ordre de 10², c'est-à-dire bien inférieurs aux rapports obtenus dans l'exemple où les régions 105a, 105b et 105c sont en tellurure de germanium. Dans ce cas, le volume de chaque région 105a, 105b, 105c est par exemple dimensionné de sorte que la valeur Rc_on soit par exemple 10 à 50 fois plus grande que chaque valeur Ra_on, Rb_on, et que la valeur Rc_off soit par exemple 10 à 50 fois plus grande que chaque valeur Ra_off, Rb_off. La région 105c présente alors par exemple un volume inférieur à celui des régions 105a et 105b. Cela permet de compenser le fait que les rapports Ra_off/Ra_on, Rb_off/Rb_on, Rc_off/Rc_on sont dans ce cas moins importants que dans le cas où les régions 105a, 105b et 105c sont en tellurure de germanium. À titre d'exemple, dans le cas où les régions 105a, 105b et 105c sont en GST :
- les valeurs Ra_on et Rb_on sont comprises entre 0,5 et 5 Ω, par exemple égales à environ 1 Ω ;
- les valeurs Ra_off et Rb_off sont comprises entre 50 et 500 Ω, par exemple égales à environ 100 Ω ;
- la valeur Rc_on est comprise entre 5 et 250 Ω, par exemple égale à environ 20 Ω ; et
- la valeur Rc_off est comprise entre 500 et 25 000 Ω, par exemple égale à environ 2 000 Ω.

La présence des éléments capacitifs Ca, Cb et Cc tient au fait que les régions en matériau à changement de phase 105a, 105b et 105c sont séparées des éléments chauffants 109a, 109b et 109c, respectivement, par la couche isolante 107. À titre d'exemple, chaque élément capacitif Ca, Cb, Cc présente, lorsque la région 105a, 105b, 105c correspondante est dans la phase amorphe, une capacité de l'ordre de 10 fF.

Par ailleurs, dans l'exemple représenté, la piste conductrice 113, dans laquelle sont formés les éléments chauffants 109a et 109b, est symbolisée par un élément résistif R1 connecté entre les électrodes de commande 111-1 et 111-2, et la piste conductrice 117, dans laquelle est formé l'élément chauffant 109c, est symbolisée par un élément résistif R2 connecté entre les électrodes de commande 115-1 et 115-2.

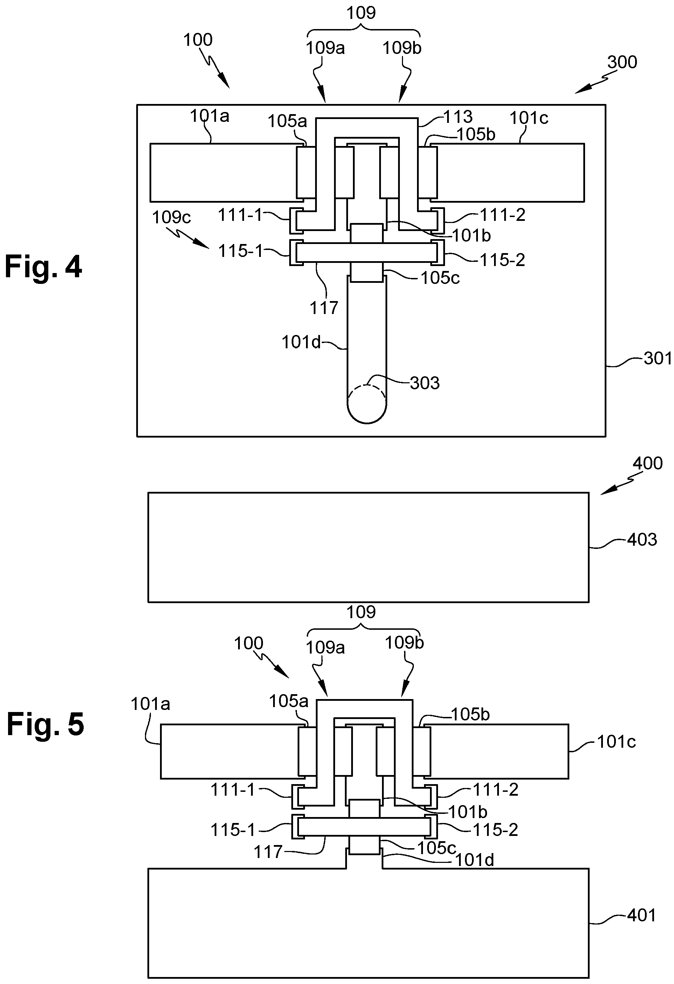

La figure 4 est une vue de dessus, schématique et partielle, d'un exemple de ligne à microruban 300 comprenant le commutateur 100 des figures 1A et 1B selon un mode de réalisation.

Dans l'exemple représenté, le commutateur 100 est situé à l'aplomb d'un plan de masse 301. La région conductrice 101d du commutateur 100 est connectée au plan de masse 301 sous-jacent par un via conducteur 303, par exemple un via métallique.

La mise en œuvre du commutateur 100 dans la ligne microruban 300 permet d'obtenir une isolation supérieure à celle qui serait obtenue avec un commutateur dépourvu de la région 105c, de la région conductrice 101d et du via 303, par exemple un commutateur ne comportant qu'une seule région en matériau à changement de phase reliant les régions conductrices 101a et 101c.

La figure 5 est une vue de dessus, schématique et partielle, d'un exemple de ligne ou guide d'ondes coplanaire 400 (« Coplanar Waveguide » - CPW, en anglais) comprenant le commutateur 100 des figures 1A et 1B selon un mode de réalisation.

Dans l'exemple représenté, le commutateur 100 est interposé latéralement entre deux plans de masse 401 et 403. Les plans de masse 401 et 403 et les régions conductrices 101a, 101b, 101c et 101d du commutateur 100 sont par exemple coplanaires. Dans l'exemple illustré, la région conductrice 101d du commutateur 100 est connectée au plan de masse 401.

La mise en œuvre du commutateur 100 dans la ligne coplanaire 400 permet d'obtenir une isolation supérieure à celle qui serait obtenue avec un commutateur dépourvu de la région 105c, de la région conductrice 101d et du via 303, par exemple un commutateur ne comportant qu'une seule région en matériau à changement de phase reliant les régions conductrices 101a et 101c.

Bien que les figures 4 et 5 illustrent des modes de réalisation dans lesquels le commutateur 100 est dépourvu de l'électrode de commande 111-3, l'électrode de commande 111-3 pourrait, à titre de variante, être prévue comme dans l'exemple exposé ci-dessus en relation avec les figures 1A et 1B.

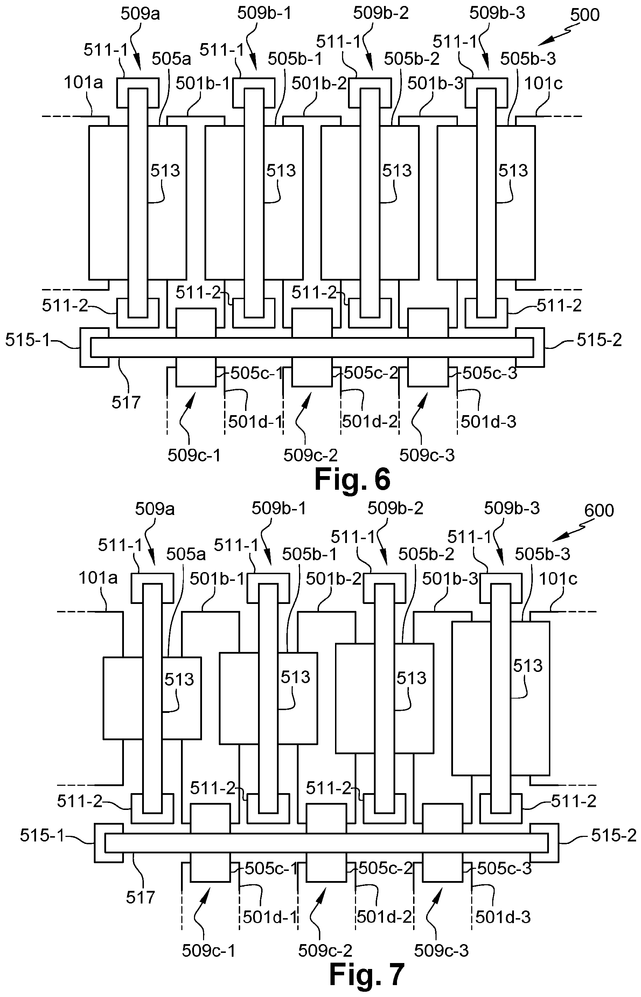

La figure 6 est une vue de dessus, schématique et partielle, d'un exemple d'un commutateur 500 à base d'un matériau à changement de phase selon un mode de réalisation.

Le commutateur 500 de la figure 6 comprend des éléments communs avec le commutateur 100 des figures 1A et 1B. Ces éléments communs ne seront pas détaillés à nouveau ci-après.

Le commutateur 500 de la figure 6 diffère du commutateur 100 des figures 1A et 1B en ce que le commutateur 500 de la figure 6 comprend une pluralité de régions conductrices intermédiaires 501b (trois régions conductrices intermédiaires 501b-1, 501b-2 et 501b-3, dans l'exemple représenté) interposées latéralement entre les régions conductrices 101a et 101c. Chaque région conductrice 501b est par exemple analogue ou identique à la région conductrice 101b du commutateur 100. Dans l'exemple illustré, le commutateur 500 comprend des régions 505a, 505b-1, 505b-2 et 505b-3 en matériau à changement de phase. La région 505a relie les régions conductrices 101a et 501b-1, la région 505b-1 relie les régions conductrices 501b-1 et 501b-2, la région 505b-2 relie les régions conductrices 501b-2 et 501b-3 et la région 505b-3 relie les régions conductrices 501b-3 et 101c. Chaque région 505a, 505b-1, 505b-2, 505b-3 est par exemple analogue ou identique aux régions 105a et 105b du commutateur 100.

Dans l'exemple représenté, le commutateur 500 comporte en outre une pluralité de régions conductrices 501d (trois régions conductrices 501d-1, 501d-2 et 501d-3, dans l'exemple représenté) situées respectivement en vis-à-vis des régions conductrices 501b. Chaque région conductrice 501d est par exemple analogue ou identique à la région conductrice 101d du commutateur 100. Dans l'exemple illustré, le commutateur 500 comporte en outre des régions 505c-1, 505c-2 et 505c-3 en matériau à changement de phase. La région 505c-1 relie les régions conductrices 501b-1 et 501d-1, la région 505c-2 relie les régions conductrices 501b-2 et 501d-2, et la région 505c-3 relie les régions conductrices 501b-3 et 501d-3. Chaque région 505c-1, 505c-2, 505c-3 est par exemple analogue ou identique aux régions 105c du commutateur 100.

Dans l'exemple illustré en figure 6, le commutateur 500 comporte en outre des éléments chauffants 509a, 509b-1, 509b-2 et 509b-3 situés respectivement à l'aplomb des régions 505a, 505b-1, 505b-2 et 505b-3 en matériau à changement de phase. Chaque élément chauffant 509a, 509b-1, 509b-2, 509b-3 est connecté entre des électrodes de commande 511-1 et 511-2 situées de part et d'autre de la direction de conduction. Dans cet exemple, chaque élément chauffant 509a, 509b-1, 509b-2, 509b-3 fait partie d'une piste conductrice 513, par exemple une piste métallique, dont les extrémités supérieure et inférieure sont connectées respectivement aux électrodes de commande 511-1 et 511-2. Les éléments chauffants 509a, 509b-1, 509b-2 et 509b-3 sont par exemple destinés à être commandés de façon simultanée.

Dans l'exemple représenté, les éléments chauffants 509a, 509b-1, 509b-2 et 509b-3 sont isolés les uns des autres. À titre de variante, les éléments chauffants 509a, 509b-1, 509b-2 et 509b-3 peuvent être connectés, par exemple au moyen d'une piste conductrice interconnectant les électrodes 511-1 des éléments chauffants 509a, 509b-1, 509b-2 et 509b-3.

Dans l'exemple illustré, le commutateur 500 comporte en outre des éléments chauffants 509c (trois éléments chauffants 509c-1, 509c-2 et 509c-3, dans l'exemple représenté) connectés en série entre des électrodes de commande 515-1 et 515-2 et faisant partie d'une même piste conductrice 517, par exemple une piste métallique, dont les extrémités gauche et droite sont connectées respectivement aux électrodes de commande 515-1 et 515-2. Les éléments chauffants 509c-1, 509c-2 et 509c-3 sont destinés à être commandés de façon simultanée, par exemple par l'application d'une différence de potentiel entre les électrodes 515-1 et 515-2.

À titre de variante, les éléments chauffants 509c-1, 509c-2 et 509c-3 peuvent être isolés électriquement l'un de l'autre. Dans ce cas, les éléments chauffants 509c-1, 509c-2 et 509c-3 sont par exemple formés dans des pistes conductrices distinctes, isolées l'une de l'autre et connectées chacune entre des électrodes de commande analogues aux électrodes 515-1 et 515-2. Dans ce cas, les électrodes de commande de chaque élément chauffant 509c-1, 509c-2, 509c-3 sont par exemple parallèles à la direction de conduction du commutateur 500. Les éléments chauffants 509c-1, 509c-2 et 509c-3 peuvent, dans cette variante, être commandés simultanément, par exemple par l'application simultanée d'une différence de potentiel entre les électrodes de commande de chaque élément chauffant 509c-1, 509c-2, 509c-3.

Les éléments chauffants 509c-1, 509c-2 et 509c-3 sont isolés électriquement des éléments chauffants 509a, 509b-1, 509b-2 et 509b-3. Cela permet de commander les éléments chauffants 509c-1, 509c-2 et 509c-3 indépendamment des éléments chauffants 509a, 509b-1, 509b-2 et 509b-3 comme exposé ci-dessus en relation avec les figures 1A et 1B pour le commutateur 100.

Le fonctionnement du commutateur 500 de la figure 6 est analogue au fonctionnement du commutateur 100 des figures 1A à 1B. La personne du métier est capable, à partir des indications de la présente description, de commander les éléments chauffants 509a, 509b-1, 509b-2, 509b-3, 509c-1, 509c-2 et 509c-3 du commutateur 500 pour obtenir des états passant, bloqué réfléchissant et bloqué absorbant analogues à ceux précédemment décrits en relation avec les figures 1A et 1B pour le commutateur 100. Le commutateur 500 présente des avantages analogues ou identiques à ceux du commutateur 100.

Le fait de prévoir plusieurs régions 505a, 505b-1, 505b-2 et 505b-3 en matériau à changement de phase permet avantageusement de réduire la quantité d'énergie électrique et la durée nécessaires à chaque commutation tout en permettant, à l'état bloqué, d'atteindre une tenue en tension élevée, par exemple supérieure ou égale à 4 V, entre les régions conductrices 101a et 101c du commutateur 500. Le commutateur 500 présente ainsi, par rapport au commutateur 100, une vitesse de commutation plus élevée, une consommation énergétique moindre et une fiabilité supérieure.

La figure 7 est une vue de dessus, schématique et partielle, d'un exemple d'un commutateur 600 à base d'un matériau à changement de phase selon un mode de réalisation.

Le commutateur 600 de la figure 7 comprend des éléments communs avec le commutateur 500 de la figure 6. Ces éléments communs ne seront pas détaillés à nouveau ci-après.

Le commutateur 600 de la figure 7 diffère du commutateur 500 de la figure 6 en ce que les régions en matériau à changement de phase 505a, 505b-1, 505b-2 et 505b-3 du commutateur 600 présentent, en vue de dessus, des aires différentes. Dans l'exemple illustré, les régions 505a, 505b-1, 505b-2 et 505b-3 présentent, le long de la direction de conduction du commutateur 600, depuis la région conductrice 101a vers la région conductrice 101c, des aires strictement croissantes. Dans l'exemple représenté, les régions 505a, 505b-1, 505b-2 et 505b-3 en matériau à changement de phase présentent la même longueur, aux dispersions de fabrication près, et des largeurs différentes, par exemple strictement croissantes entre les deux régions conductrices 101a et 101c du commutateur 600. À titre d'exemple, la région conductrice 101c en contact avec la région 505b-3 présentant l'aire la plus grande est adaptée à être portée à un potentiel haut, par exemple supérieur ou égal à 4 V, l'autre région conductrice 101a, en contact avec la région 505a présentant l'aire la plus petite, dans cet exemple, étant destinée à être portée à un potentiel de référence, par exemple la masse. Par ailleurs, l'écart d'aires, ou de largeurs, entre deux régions 505a, 505b-1, 505b-2, 505b-3 successives est d'autant plus important que les régions 505a, 505b-1, 505b-2 et 505b-3 sont proches de la région conductrice 101c en contact avec la région 505b-3 présentant l'aire la plus grande (proches de l'extrémité droite, dans l'orientation de la figure 7).

La largeur, ou l'aire, de chaque région 505a, 505b-1, 505b-2, 505b-3 est par exemple déterminée de sorte que, lorsque le commutateur 600 est à l'état bloqué et qu'une tension, résultant de l'application du signal radiofréquence, est appliquée entre ses régions conductrices 101a et 101c, les tensions résultantes individuellement appliquées à chaque région 505a, 505b-1, 505b-2, 505b-3, c'est-à-dire, pour chaque région 505a, 505b-1, 505b-2, 505b-3, la tension appliquée entre les deux régions conductrices qu'elle relie, soient sensiblement identiques, ou équilibrées. Cela permet avantageusement d'améliorer la tenue en tension du commutateur 600 par rapport au commutateur 500.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable, dans la ligne microruban 300 ou dans la ligne coplanaire 400, de remplacer le commutateur 100 par le commutateur 500 ou par le commutateur 600.

Enfin, la mise en œuvre pratique des modes de réalisation et variantes décrits est à la portée de la personne du métier à partir des indications fonctionnelles données ci-dessus. En particulier, la personne du métier est capable, à partir des indications de la présente description, de choisir le matériau et de dimensionner le volume de chaque région en matériau à changement de phase en fonction des caractéristiques électriques recherchées.

## Revendications

1. Commutateur (100 ; 500 ; 600) comprenant :
- des première, deuxième, troisième et quatrième régions conductrices (101a, 101b, 101c, 101d ; 101a, 501b-1, 501b-2, 501d-1) ;
- une première région (105a ; 505a) en un matériau à changement de phase reliant les première et deuxième régions conductrices ;
- une deuxième région (105b ; 505b-1) en un matériau à changement de phase reliant les deuxième et troisième régions conductrices ; et
- une troisième région (105c ; 505c-1) en un matériau à changement de phase reliant les deuxième et quatrième régions conductrices, la troisième région conductrice étant destinée à être portée à un potentiel de référence, de préférence la masse,
dans lequel les première et deuxième régions en matériau à changement de phase sont destinées à transmettre un signal radiofréquence.

2. Commutateur (100) selon la revendication 1, dans lequel :
- les première et troisième régions conductrices (101a, 101c) forment des électrodes de conduction du commutateur ; et
- la quatrième région conductrice (101d) forme une électrode de référence du commutateur.

3. Commutateur selon la revendication 1 ou 2, comprenant en outre des premier, deuxième et troisième éléments chauffants (109a, 109b, 109c ; 509a, 509b-1, 509c-1) situés respectivement en vis-à-vis des première, deuxième et troisième régions (105a, 105b, 105c ; 505a, 505b-1, 505c-1) en matériau à changement de phase, chaque élément chauffant étant électriquement isolé de ladite région située en vis-à-vis.

4. Commutateur selon la revendication 3, dans lequel les premier et deuxième éléments chauffants (109a, 109b) forment un unique élément chauffant (109).

5. Commutateur selon la revendication 3 ou 4, dans lequel le troisième élément chauffant (109c ; 509c-1) est destiné à être commandé indépendamment des premier et deuxième éléments chauffants (109a, 109b ; 509a, 509b-1).

6. Commutateur selon la revendication 3, 4 ou 5, dans lequel les premier et deuxième éléments chauffants (109a, 109b ; 509a, 509b-1) sont destinés à être commandés simultanément.

7. Commutateur selon l'une quelconque des revendications 3 à 6, dans lequel les premier et deuxième éléments chauffants (109a, 109b ; 509a, 509b-1) sont connectés en série entre des première et deuxième électrodes de commande (111-1, 111-2).

8. Commutateur selon la revendication 7, dans lequel :
- le premier élément chauffant est connecté entre la première électrode de commande (111-1) et une troisième électrode de commande (111-3) ; et
- le deuxième élément chauffant est connecté entre la deuxième électrode de commande (111-2) et la troisième électrode de commande (111-3).

9. Commutateur selon l'une quelconque des revendications 3 à 7, dans lequel le troisième élément chauffant (109c) est destiné à être commandé de sorte à faire passer la troisième région (105c ; 505c-1) en matériau à changement de phase d'un premier état à un deuxième état lorsque les premier et deuxième éléments chauffants (109a, 109b ; 509a, 509b-1) sont commandés de sorte à faire passer les première et deuxième régions (105a, 105b ; 505a, 505b-1) en matériau à changement de phase du deuxième au premier état.

10. Commutateur selon l'une quelconque des revendications 1 à 9, dans lequel les première, deuxième et troisième régions (105a, 105b, 105c ; 505a, 505b-1, 505c-1) en matériau à changement de phase sont en un matériau chalcogénure.

11. Commutateur selon la revendication 10, dans lequel chacune des première, deuxième et troisième régions (105a, 105b, 105c ; 505a, 505b-1, 505c-1) en matériau à changement de phase est en tellurure de germanium ou en germanium-antimoine-tellure.

12. Commutateur selon l'une quelconque des revendications 1 à 11, dans lequel la troisième région (105c ; 505c-1) en matériau à changement de phase présente un volume inférieur à celui des première et deuxième régions (105a, 105b ; 505a, 505b-1) en matériau à changement de phase.

13. Commutateur (600) selon l'une quelconque des revendications 1 à 12, dans lequel les première et deuxième régions (505a, 505b-1) en matériau à changement de phase présentent, en vue de dessus, des aires différentes.

14. Commutateur selon l'une quelconque des revendications 1 à 13, dans lequel les première et deuxième régions (105a, 105b ; 505a, 505b-1) en matériau à changement de phase présentent, le long de la direction de conduction du commutateur, une même dimension latérale.

15. Commutateur (600) selon l'une quelconque des revendications 1 à 14, dans lequel les première et deuxième régions (505a, 505b-1) en matériau à changement de phase présentent, le long d'une direction orthogonale à la direction de conduction du commutateur, des dimensions latérales différentes.

16. Dispositif (300 ; 400) comprenant un commutateur (100 ; 500 ; 600) selon l'une quelconque des revendications 1 à 15 et un plan de masse (301 ; 401) auquel est connectée la quatrième région conductrice (101d ; 501d-1) du commutateur.

## Patentansprüche

1. Schalter (100; 500; 600), aufweisend:
- erste, zweite, dritte und vierte leitfähige Bereiche (101a, 101b, 101c, 101d; 101a, 501b-1, 501b-2, 501d-1);
- einen ersten Bereich (105a; 505a) aus einem Phasenwechselmaterial, das die ersten und zweiten leitfähigen Bereiche koppelt;
- einen zweiten Bereich (105b; 505b-1) aus einem Phasenwechselmaterial, das die zweiten und dritten leitfähigen Bereiche koppelt; und
- einen dritten Bereich (105c; 505c-1) aus einem Phasenwechselmaterial, das die zweiten und vierten leitfähigen Bereiche koppelt, wobei der dritte leitfähige Bereich dazu vorgesehen ist, auf ein Referenzpotential gebracht zu werden, vorzugsweise auf Masse,
wobei die ersten und zweiten Bereiche aus Phasenwechselmaterial dazu vorgesehen sind, ein Hochfrequenzsignal zu übertragen.

2. Schalter (100) gemäß Anspruch 1, wobei:
- die ersten und dritten leitfähigen Bereiche (101a, 101c) Leitungselektroden des Schalters bilden; und
- der vierte leitfähige Bereich (101d) eine Referenzelektrode des Schalters bildet.

3. Schalter gemäß Anspruch 1 oder 2, der ferner erste, zweite und dritte Heizelemente (109a, 109b, 109c; 509a, 509b-1, 509c-1) aufweist, die jeweils gegenüberliegend zu dem ersten, zweiten und dritten Bereich (105a, 105b, 105c; 505a, 505b-1, 505c-1) des Phasenwechselmaterials angeordnet sind, wobei jedes Heizelement von dem gegenüberlegenden Bereich elektrisch isoliert ist.

4. Schalter gemäß Anspruch 3, wobei das erste und das zweite Heizelement (109a, 109b) ein einziges Heizelement (109) bilden.

5. Schalter gemäß Anspruch 3 oder 4, wobei das dritte Heizelement (109c; 509c-1) unabhängig von den ersten und zweiten Heizelementen (109a, 109b; 509a, 509b-1) gesteuert werden soll.

6. Schalter gemäß Anspruch 3, 4 oder 5, wobei die ersten und zweiten Heizelemente (109a, 109b; 509a, 509b-1) dazu vorgesehen sind, gleichzeitig gesteuert zu werden.

7. Schalter gemäß einem der Ansprüche 3 bis 6, wobei die ersten und zweiten Heizelemente (109a, 109b; 509a, 509b-1) zwischen einer ersten und einer zweiten Steuerelektrode (111-1, 111-2) in Reihe geschaltet sind.

8. Schalter gemäß Anspruch 7, wobei:
- das erste Heizelement zwischen der ersten Steuerelektrode (111-1) und einer dritten Steuerelektrode (111-3) angeschlossen ist; und
- das zweite Heizelement zwischen der zweiten Steuerelektrode (111-2) und der dritten Steuerelektrode (111-3) angeschlossen ist.

9. Schalter gemäß einem der Ansprüche 3 bis 7, wobei das dritte Heizelement (109c) so gesteuert werden soll, dass der dritte Bereich (105c; 505c-1) des Phasenwechselmaterials von einem ersten Zustand in einen zweiten Zustand wechselt, wenn das erste und das zweite Heizelement (109a, 109b; 509a, 509b-1) so gesteuert werden, dass die ersten und zweiten Bereiche (105a, 105b; 505a, 505b-1) des Phasenwechselmaterials vom zweiten in den ersten Zustand wechseln.

10. Schalter gemäß einem der Ansprüche 1 bis 9, wobei die ersten, zweiten und dritten Bereiche (105a, 105b, 105c; 505a, 505b-1, 505c-1) des Phasenwechselmaterials aus einem Chalcogenid-Material bestehen.

11. Schalter gemäß Anspruch 10, wobei jeder der ersten, zweiten und dritten Bereiche (105a, 105b, 105c; 505a, 505b-1, 505c-1) des Phasenwechselmaterials aus Germanium-Tellurid oder aus Germanium-Antimon-Tellur besteht.

12. Schalter gemäß einem der Ansprüche 1 bis 11, wobei der dritte Bereich (105c; 505c-1) des Phasenwechselmaterials ein kleineres Volumen als die ersten und zweiten Bereiche (105a, 105b; 505a, 505b-1) des Phasenwechselmaterials aufweist.

13. Schalter (600) gemäß einem der Ansprüche 1 bis 12, wobei die ersten und zweiten Bereiche (505a, 505b-1) des Phasenwechselmaterials in der Draufsicht unterschiedliche Flächen aufweisen.

14. Schalter gemäß einem der Ansprüche 1 bis 13, wobei die ersten und zweiten Bereiche (105a, 105b; 505a, 505b-1) des Phasenwechselmaterials entlang der Schalter-Leitungsrichtung eine gleiche Querabmessung aufweisen.

15. Schalter (600) gemäß einem der Ansprüche 1 bis 14, wobei die ersten und zweiten Bereiche (505a, 505b-1) des Phasenwechselmaterials entlang einer Richtung orthogonal zur Schalter-Leitungsrichtung unterschiedliche laterale Abmessungen aufweisen.

16. Vorrichtung (300; 400), die einen Schalter (100; 500; 600) gemäß einem der Ansprüche 1 bis 15 und eine Grundplatte (301; 401) aufweist, mit der der vierte leitfähige Bereich (101d; 501d-1) des Schalters verbunden ist.

## Claims

1. Switch (100; 500; 600) comprising:
- first, second, third, and fourth conductive regions (101a, 101b, 101c, 101d; 101a, 501b-1, 501b-2, 501d-1);
- a first region (105a; 505a) made of a phase-change material coupling the first and second conductive regions;
- a second region (105b; 505b-1) made of a phase-change material coupling the second and third conductive regions; and
- a third region (105c; 505c-1) made of a phase-change material coupling the second and fourth conductive regions, the third conductive region being intended to be taken to a reference potential, preferably the ground,
wherein the first and second regions of phase-change material are intended to transmit a radio frequency signal.

2. Switch (100) according to claim 1, wherein:
- the first and third conductive regions (101a, 101c) form conduction electrodes of the switch; and
- the fourth conductive region (101d) forms a reference electrode of the switch.

3. Switch according to claim 1 or 2, further comprising first, second, and third heater elements (109a, 109b, 109c; 509a, 509b-1, 509c-1) respectively located opposite first, second, and third regions (105a, 105b, 105c; 505a, 505b-1, 505c-1) of phase-change material, each heater element being electrically insulated from said opposite region.

4. Switch according to claim 3, wherein the first and second heater elements (109a, 109b) form a single heater element (109).

5. Switch according to claim 3 or 4, wherein the third heater element (109c; 509c-1) is intended to be controlled independently from the first and second heater elements (109a, 109b; 509a, 509b-1).

6. Switch according to claim 3, 4 or 5, wherein the first and second heater elements (109a, 109b; 509a, 509b-1) are intended to be controlled simultaneously.

7. Switch according to any of claims 3 to 6, wherein the first and second heater elements (109a, 109b; 509a, 509b-1) are series-connected between first and second control electrodes (111-1, 111-2).

8. Switch according to claim 7, wherein:
- the first heater element is connected between the first control electrode (111-1) and a third control electrode (111-3); and
- the second heater element is connected between the second control electrode (111-2) and the third control electrode (111-3).

9. Switch according to any of claims 3 to 7, wherein the third heater element (109c) is intended to be controlled in such a way as to have the third region (105c; 505c-1) of phase-change material change from a first state to a second state when the first and second heater elements (109a, 109b; 509a, 509b-1) are controlled in such a way as to have the first and second regions (105a, 105b; 505a, 505b-1) of phase-change material change from the second to the first state.

10. Switch according to any of claims 1 to 9, wherein the first, second, and third regions (105a, 105b, 105c; 505a, 505b-1, 505c-1) of phase-change material are made of a chalcogenide material.

11. Switch according to claim 10, wherein each of the first, second, and third regions (105a, 105b, 105c; 505a, 505b-1, 505c-1) of phase-change material is made of germanium telluride or of germanium-antimony-tellurium.

12. Switch according to any of claims 1 to 11, wherein the third region (105c; 505c-1) of phase-change material has a volume smaller than that of the first and second regions (105a, 105b; 505a, 505b-1) of phase-change material.

13. Switch (600) according to any of claims 1 to 12, wherein the first and second regions (505a, 505b-1) of phase-change material have, in top view, different areas.

14. Switch according to any of claims 1 to 13, wherein the first and second regions (105a, 105b; 505a, 505b-1) of phase-change material have, along the switch conduction direction, a same lateral dimension.

15. Switch (600) according to any of claims 1 to 14, wherein the first and second regions (505a, 505b-1) of phase-change material have, along a direction orthogonal to the switch conduction direction, different lateral dimensions.

16. Device (300; 400) comprising a switch (100; 500; 600) according to any of claims 1 to 15 and a ground plane (301; 401) having the fourth conductive region (101d; 501d-1) of the switch connected thereto.
